# EUROPEAN PATENT SPECIFICATION

(11) **EP 0 601 603 B1**
(45) Date of publication and mention of the grant of the patent: **05.06.1996**
(21) Application number: 93119983.0
(22) Date of filing: 10.12.1993
(51) Int. Cl.: H05K 13/02

(54) **Chip component supply equipment**
Verzorgungsvorrichtung von Bauelement für integrierte Schaltung
Equipement pour la fourniture de composant pour circuit intégré

(30) Priority: 10.12.1992 JP 330241/92
(43) Date of publication of application: 15.06.1994
(73) Proprietor: MATSUSHITA ELECTRIC INDUSTRIAL CO., LTD., Kadoma-shi, Osaka-fu, 571 (JP)
(72) Inventor: Soga, Tomitatu, Hirakata-shi, Osaka, 573 (JP); Tanaka, Kunio, Kadoma-shi, Osaka, 571 (JP); Negishi, Shigetoshi, Suita-shi, Osaka, 565 (JP); Nakamura, Hidekazu, Ibaraki-shi, Osaka, 567 (JP); Fujiwara, Hiroyuki, Minamikawachi-gun, Osaka, 587 (JP); Kato, Kenji, Hirakata-shi, Osaka, 573 (JP); Fujita, Takayuki, Hirakata-shi, Osaka, 573 (JP); Nakanishi, Tahashi, Ashiya-shi, Hyogo, 659 (JP)
(74) Representative: Grünecker, Kinkeldey, Stockmair & Schwanhäusser Anwaltssozietät

(56) References cited:
- EP-A- 0 301 691
- GB-A- 2 244 482
- US-A- 4 459 743

## Description

The present invention relates to a chip component supply equipment according to the preamble part of claim 1 which is used in an electronic component placement machine for mounting chip electronic components (hereinafter called chip components) on a circuit board.

Such a chip component supply equipment is known for example from GB-A-2 244 482.

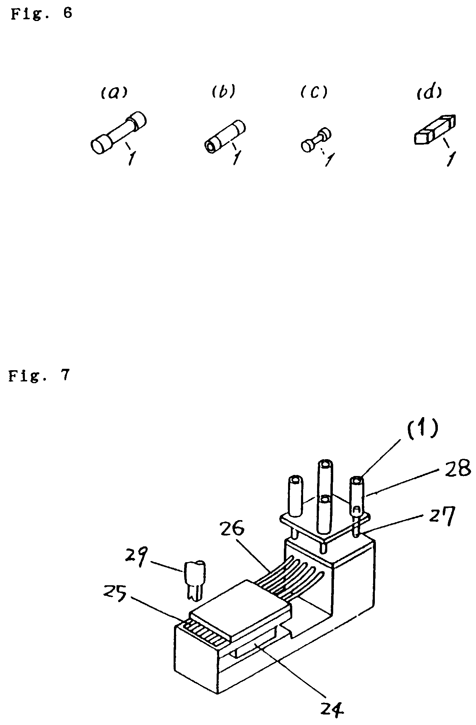

The chip component supply equipment is used in order that chip components supplied in pieces as shown in Fig. 6 (a) to (d) may be sent successively into the electronic component placement machine, as being positioned at specified places in specified posture, so as to be taken out by a vacuum suction nozzle. A conventional chip component supply equipment is shown in Fig. 7.

In Fig. 7, chip components 1 are stored in pieces in a hopper 28, and a fixed pipe 27 is slidably inserted in the bottom of the hopper 28. The hopper 28 is driven vertically by oscillating means not shown in the drawing, and the chip components 1 drop into the pipe 27. The dropped chip comporeach a feeder 24 through a coupled flexible pipe 26, and are driven by the feeder 24 to be carried up to a take-out port 25. The chip components are successively taken out by a vacuum suction nozzle 29 of an electronic component placement machine (not shown) at the take-out port 25, and are mounted on a circuit board. In such conventional chip component supply equipment, however, chip components may pop out of the equipment or be positioned irregularly due to vibrations of the equipment. Or, the succeeding chip components driven by the feeder 24 may push the chip components staying at the take-out port 25 with a very strong pressure, and the vacuum suction nozzle 29 may fail to take them out occasionally. Yet, irregular chip components broken by some accident may cause jamming in the take-out port 25, and the operation of the electronic component placement machine may be stopped.

The invention presents a chip component supply equipment of a novel constitution eliminating the possibility of such troubles.

The chip component supply equipment of the invention comprises:
a container box for storing chip components in pieces,
means for conveying chip components from the container box onto a conveyor belt,
a conveyor belt moving intermittently for conveying the transferred chip components toward a take-out port where a vacuum suction nozzle of an electronic component placement machine takes out chip components, and
a stopper positioned at the take-out port for stopping the chip components conveyed by the conveyor belt at the take-out port,
wherein the stopper moves and departs from the take-out port when the conveyor belt finishes intermittent motion and stops, and returns and is positioned at the take-out port before the next chip component conveyed by next intermittent motion of the conveyor belt reaches the take-out port.

The vacuum suction nozzle of the electronic component placement machine takes out the chip component at the take-out port when the conveyor belt is stopped and the stopper is apart from the take-out port.

Since the conveyor belt 7 is stopped, the chip component at the take-out port is not pushed by the succeeding chip component or is not moved by the vibration of the conveyor belt 7. This facilitates the work of the vacuum suction nozzle to take out the chip component. Furthermore, since the stopper is apart from the take-out part, there is no risk of interference of the vacuum suction nozzle and the chip component to be taken out with the stopper, and irregular chip components will not cause jamming in the take-out port. The benefits also contribute to the ease of work of the vacuum suction nozzle to take out the chip components.

Fig. 1 is a perspective view showing an embodiment of chip component supply equipment of the invention.

Fig. 2 is a sectional view of a conveyor belt included in the embodiment of chip component supply equipment of the invention.

Fig. 3 is a diagram explaining the action of a stopper included in the embodiment of chip component supply equipment of the invention.

Fig. 4 is a diagram showing the motion of one cycle of chip component supply equipment of the invention.

Fig. 5 (a), (b) are sectional views of a container box and a take-out pipe included in the embodiment of chip component supply equipment of the invention.

Fig. 6 is a perspective view of several types of chip components.

Fig. 7 is a conventional chip component supply equipment.

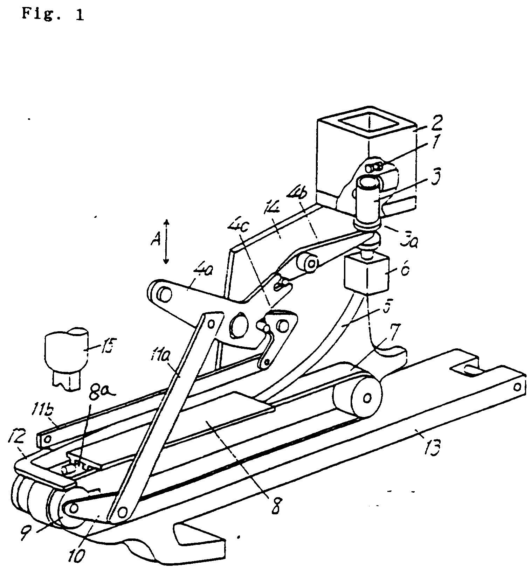

In Fig. 1, a container box 2 stores a lot of chip components 1 in pieces. A hollow movable pipe 3 is coupled slidably to the bottom of the container box 2. Arrow A indicates the vertical motion of a lever 4a.

An electronic component placement machine (not shown) comprises plural sets of chip component supply equipment storing different types of chip components, and the lever 4a of the chip component supply equipment containing the chip components to be mounted is vertically driven by an actuator (not shown) of the electronic component placement machine selectively, and the chip component conveyed to the take-out port is taken out by a vacuum suction nozzle 15, and is mounted on a circuit board.

The motion of the lever 4a is transmitted to a neck portion 3a lowered in the lower part of the movable pipe 3 through a lever 4b, and drives the movable pipe 3 vertically inside the container box 2.

By this motion, the chip components 1 stored in the container box 2 are successively dropped into the movable pipe 3, and the dropped chip components pass through the movable pipe 3 and a conveying tube 5 extended downward as being coupled to the movable pipe 3, and are discharged to the terminal end of the conveying tube 5. The conveying tube 5 is fixed to a side wall 14 by a holder 6.

The terminal end of the conveying tube 5 is inserted into a guide groove 8a of a guide cover 8 mounted on a conveyor belt 7. The chip components 1 discharged from the terminal end of the conveying tube 5 are aligned in the guide groove 8a, and conveyed toward the take-out port where the vacuum suction nozzle 15 of the electronic component placement machine takes out the chip components, near the left end of the conveyor belt 7, by the conveyor belt 7 which moves intermittently.

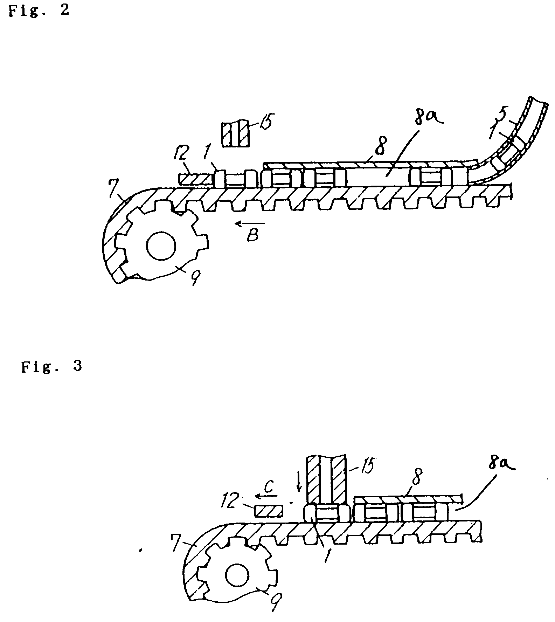

The motion from the top dead center to the bottom dead center of the lever 4a does not move a ratchet wheel 9, but the motion from the bottom dead center to the top dead center rotates the ratchet wheel 9 by a specific angle, through a linkage piece 11a and a ratchet 10. That is, the conveyor belt 7 moves intermittently in the direction of arrow B in Fig. 2 by one vertical stroke of the lever 4a. The moving distance by one intermittent motion of the conveyor belt 7 is set longer than the length of the chip components 1 to be conveyed.

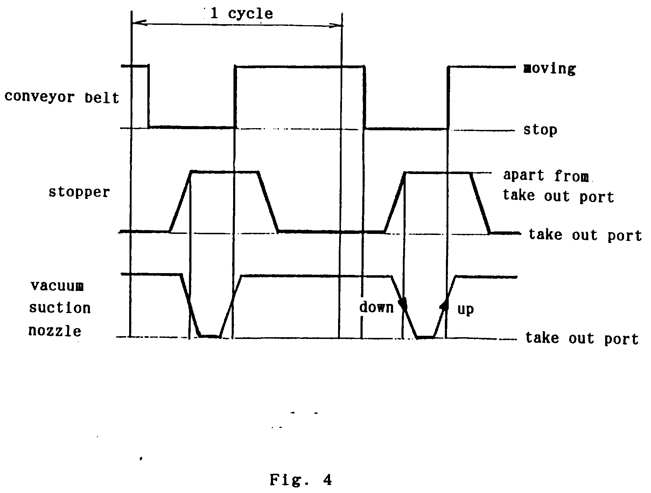

One cycle of motion of the conveyor belt 7, stopper 12, and vacuum suction nozzle 15 are summarized as follows. This is shown in Fig. 4.
(1) The chip components 1 moving together with the conveyor belt 7 on the intermittently moving conveyor belt 7 are prevented from moving together with the conveyor belt 7 by the stopper 12 located at the take-out port, and stopped. Between the stopped chip components 1 and the conveyor belt 7, slipping occurs from the end of intermittent motion until stopping of the conveyor belt 7.
(2) When the conveyor belt 7 stops, as shown in Fig. 3, the stopper 12 moves in the direction of arrow C, and departs from the chip components stopped at the take-out port.
(3) The vacuum suction nozzle 15 descends, and sucks the chip component 1, and then ascends.
(4) The conveyor belt conveys the next chip component toward the take-out port.
(5) The stopper 12 returns toward the take-out port so as to be located at the take-out port before the next chip component reaches the take-out port.

These steps are the motion of one cycle of the chip component supply equipment. By repeating the motion of this one cycle, chip components are taken out successively.

In this way, the vacuum suction nozzle of the electronic component placement machine takes out the chip at the take-out port while the conveyor belt is stopped and the stopper is apart from the take-out port.

Since the conveyor belt 7 is stopped, the chip component at the take-out port will not be pushed by the succeeding chip component, or not be moved by the vibration of the conveyor belt 7. This facilitates the work of the vacuum suction nozzle to take out the chip component. Moreover, since the stopper is apart from the take-out portion, there is no risk of interference of the vacuum suction nozzle and the chip component to be taken out with the stopper, and irregular chip components will not cause jamming in the take-out port. All these benefits make it easier for the vacuum suction nozzle to take out the chip components.

In the foregoing embodiment, the vertical motion of the movable pipe 3 in the container box 2, the intermittent motion of the conveyor belt 7, and the motion of the stopper are all created by the power of the actuator of the electronic component placement machine for moving the lever 4a vertically. The invention is, however, not limited to this embodiment only. For example, the movable pipe 3, conveyor belt 7, and stopper 12 may comprise known driving sources such as motor or solenoid, and these driving sources cooperate to produce the same motions as in the embodiment, thereby realizing the invention.

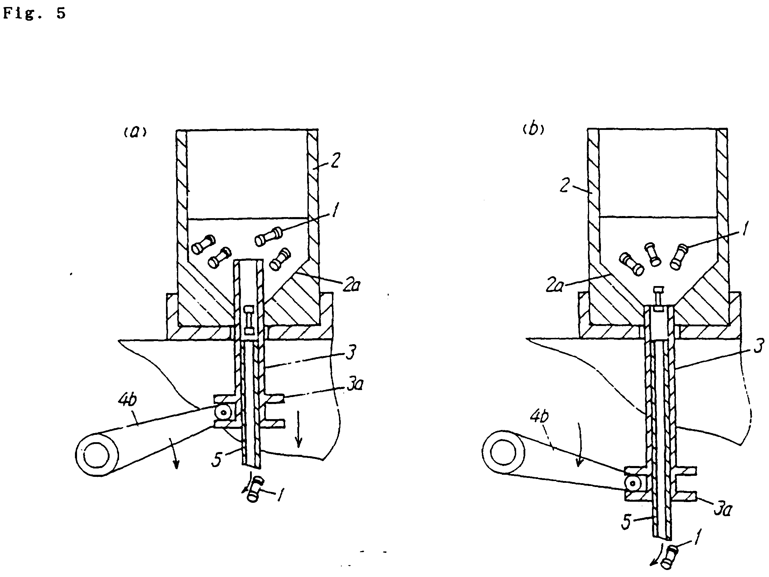

Fig. 5 shows the movable pipe 3 making vertical motions in the container box 2 storing multiple chip components 1 in pieces. The movable pipe 3 is slidably coupled with the container box 2 and conveying tube 5, and is driven by the lever 4b to make vertical motions, and thereby the chip components 1 drop inside, and the dropped chip components 1 are conveyed onto the conveyor belt 7 through the movable pipe 3 and conveying tube 5.

In one cycle of vertical motion of the movable pipe 3, the movable pipe 3 initially at the upper end of the motion as shown in Fig. 5 (a) goes to the lower end as shown in Fig. 5 (b), and immediately returns to the upper end. Thus, as compared with its reverse motion, that is, the movable pipe 3 initially at the lower end of the motion going to the upper end and returning to the lower end, the number of chip components 1 falling into the movable pipe 3 is increased, so that the chip components 1 may be supplied more securely.

A slope 2a inside the container box 2 makes it easier to concentrate the chip components in one position.

## Claims

1. A chip component supply equipment comprising:
a container box (2) for storing chip components (1) in pieces,
means (3,5,6) for conveying chip components (1) from the container box onto a take-out port,
a stopper (12) positioned at the take-out port for stopping the chip components (1) conveyed to the take out port, where a vacuum suction nozzle (15) of an electronic component placement machine takes out chip components (1)
**characterized by**
a conveyor belt (7) moving intermittently for conveying the transferred chip components (1) toward the take-out port, and in that
the stopper (12) moves and departs from the take-out port when the conveyor belt (7) finishes intermittent motion and stops, and returns and is positioned at the take-out port before the new chip component (1) conveyed by next intermittent motion of the conveyor belt reaches the take-out port.

2. A chip component supply equipment according to claim 1, wherein the means for conveying chip components from the container boy (2) onto the conveyor belt (7) comprises:
a movable pipe (3) slidably coupled to the bottom of the container box (2) at one end, being driven so that the same end may be moved up and down intermittently in the container box, (2) and
a conveying tube (5) coupled to the movable pipe and extended downward.

3. A chip component supply equipment according to claim 2, wherein the movable pipe (3) intermittently repeats motions of one cycle moving vertically, and the motion of one cycle comprises:
(1) the movable pipe (3) moving initially to the upper end of motion, and
(2) the movable pipe (3) going to the lower end of motion, then returning to the upper end immediately.

4. A chip component supply equipment according to claim 1, wherein the moving distance by one intermittent motion of the conveyor belt (7) is longer than the length of the chip components (1) to be conveyed.

## Patentansprüche

1. Gerät zum Zuführen von Chipkomponenten umfassend:
einen Containerbehälter (2) zum Aufbewahren der Chipkomponenten (1) in Teilen,
eine Einrichtung (3, 5, 6) zum Fördern der Chipkomponenten (1) aus dem Containerbehälter zu einem Abführkanal,
einen Stopper (12), der an dem Abführkanal angeordnet ist zum Stoppen der Chipkomponenten (1), die zum Abführkanal gefördert werden, wo ein Vakuum-Saugdüse (15) einer Bestückungsmaschine für elektronische Komponenten die Chipkomponenten (1) abführt,
**gekennzeichnet durch**
ein Förderband (7), welches sich intermittierend bewegt zum Fördern der transferierten Chipkomponenten (1) zu dem Abführkanal und dadurch,
daß der Stopper (12) sich auf den Abführkanal zu bewegt und sich von diesem entfernt, wenn das Förderband (7) die intermittierende Bewegung beendet und anhält, und zurückkehrt und an dem Abführkanal angeordnet ist, bevor die neue Chipkomponente (1), welche von der nächsten intermittierenden Bewegung des Förderbandes gefördert wird, den Abführkanal erreicht.

2. Gerät zum Zuführen von Chipkomponenten nach Anspruch 1, worin die Einrichtung zum Fördern der Chipkomponenten von dem Containerbehälter (2) auf das Förderband (7) umfaßt:
ein bewegliches Rohr (3), welches mit einem Ende an dem Boden des Containerbehälters (2) gleitend verbunden ist und so angetrieben wird, daß das gleiche Ende intermittierend aufwärts und abwärts in dem Containerbehälter (2) bewegt wird und
ein Förderrohr (5), welches mit dem beweglichen Rohr verbunden ist und sich nach unten erstreckt.

3. Gerät zum Zuführen von Chipkomponenten nach Anspruch 2, worin das bewegliche Rohr (3) intermittierend Bewegungen wiederholt in einem Zyklus ausführt, wobei es sich vertikal bewegt und die Zyklusbewegung umfaßt:
(1) das bewegliche Rohr (3) bewegt sich anfangs zum oberen Ende der Bewegung, und
(2) das bewegliche Rohr bewegt sich zum unteren Ende der Bewegung und kehrt dann sofort zum oberen Ende zurück.

4. Gerät zum Zuführen von Chipkomponenten nach Anspruch 1, worin der Bewegungsabstand einer intermittierenden Bewegung des Förderbandes (7) länger ist als die Länge der zu fördernden Chipkomponenten (1).

## Revendications

1. Equipement pour la fourniture de composants pour circuit intégré, comportant :
une boîte (2) formant conteneur pour recevoir des composants pour circuit intégré (1) par éléments,
des moyens (3, 5, 6) pour transporter les composants pour circuit intégré (1) à partir de la boîte formant conteneur vers un orifice d'extraction,
une butée (12), positionnée au niveau de l'orifice d'extraction, pour arrêter les composants pour circuit intégré (1) transportés vers l'orifice d'extraction, au niveau duquel une buse d'aspiration (15) d'une machine de positionnement de composants électroniques extrait les composants pour circuit intégré (1)
caractérisé par
une courroie de transport (7), se déplaçant de manière intermittente pour transporter les composants pour circuit intégré (1) transférés, vers l'orifice d'extraction, et en ce que
la butée (12) se met en mouvement et s'écarte de l'orifice d'extraction lorsque la courroie de transport (7) termine son mouvement intermittent et s'arrête, et retourne se positionner au niveau de l'orifice d'extraction avant que le nouveau composant pour circuit intégré (1), transporté grâce au mouvement intermittent suivant de la courroie de transport, n'atteigne l'orifice d'extraction.

2. Equipement pour la fourniture de composants pour circuit intégré selon la revendication 1, dans lequel les moyens pour transporter les composants pour circuit intégré à partir de la boîte (2) formant conteneur, sur la courroie de transport (7), comportent :
un tuyau mobile (3), relié de manière coulissante, par une première extrémité, au fond de la boîte (2) formant conteneur, entraîné de telle sorte que cette même extrémité puisse être déplacée vers le haut et vers le bas de manière intermittente dans la boîte (2) formant conteneur, et
un tube de transport (5) relié au tuyau mobile et s'étendant vers le bas.

3. Equipement pour la fourniture de composants pour circuit intégré selon la revendication 2, dans lequel le tuyau mobile (3) répète de manière intermittente des mouvements d'un cycle de déplacement vertical, et le mouvement d'un cycle est tel que :
(1) le tuyau mobile (3) se déplace initialement jusqu'à l'extrémité supérieure du mouvement et
(2) le tuyau mobile (3) se déplace jusqu'à l'extrémité inférieure du mouvement, et retourne ensuite immédiatement à l'extrémité supérieure.

4. Equipement pour la fourniture de composants pour circuit intégré selon la revendication 1, dans lequel la distance de déplacement obtenue par un mouvement intermittent de la courroie de transport (7) est supérieure à la longueur des composants pour circuit intégré (1) à transporter.
